Europäisches Patentamt

European Patent Office

Office européen des brevets

(19)

(11) Veröffentlichungsnummer: **0 229 265**
**B1**

(12) **EUROPÄISCHE PATENTSCHRIFT**

(45) Veröffentlichungstag der Patentschrift: **13.06.90**

(21) Anmeldenummer: **86116129.7**

(22) Anmeldetag: **21.11.86**

(51) Int. Cl.⁵: **F 23 N 5/08, H 03 K 5/01,**
**G 01 R 23/15**

(54) Wechselstrahlungsflammenwächter mit Störsignalunterdrückung.

(30) Priorität: **23.12.85 DD 285178**

(43) Veröffentlichungstag der Anmeldung:
**22.07.87 Patentblatt 87/30**

(45) Bekanntmachung des Hinweises auf die
Patenterteilung:
**13.06.90 Patentblatt 90/24**

(84) Benannte Vertragsstaaten:
**AT CH DE FR LI**

(56) Entgegenhaltungen:
**DD-A- 145 873**
**DE-A-2 716 044**
**US-A-4 308 502**

(73) Patentinhaber: **VEB Geräte- und Regler-Werk**
**Leipzig**
**Baalsdorfer Strasse 55**
**DDR-7027 Leipzig (DD)**

(72) Erfinder: **Podbielski, Martin**
**Ringstrasse 12**
**DDR-Torgau 7290 (DD)**
Erfinder: **Ceschia, Michael, Dipl.-Ing.**
**Bruno-Leuschner-Strasse 35**
**DDR Leipzig 7025 (DD)**

(74) Vertreter: **Patentanwälte Beetz sen. - Beetz jun.**
**Timpe - Siegfried - Schmitt-Fumian**
**Steinsdorfstrasse 10**
**D-8000 München 22 (DE)**

Courier Press, Leamington Spa, England.

**Beschreibung**

Die Erfindung betrifft einen Wechselstrahlungsflammenwächter mit Unterdrückung von Störsignalen bekannten Frequenz zur Flammenüberwachung von vorwiegend Einzelbrennerfeuerungen für feste, flüssige oder gasförmige Brennstoffe, der aus einer optoelektronischen Fühlereinheit und einer elektronischen Auswerte- und Schalteinheit besteht und bei dem an das optoelektronische Fühlerelement ein Impulsformer, der eine Rechtecksignalspannung erzeugt, angeschlossen ist und bei dem am Ausgang durch einen Kondensator galvanisch getrennt eine Gleichrichterschaltung vorhanden ist, an die sich eine Schalteinheit anschließt.

Flammenwächter haben allgemein die Aufgabe, bei Flammenausfall eine Unterbrechung der Brennstoffzufuhr zu veranlassen, um die Bildung von explosiven Gemischen im Brennerraum zu verhindern. In bekannten Lösungen wird u. a. als Überwachungskriterium der Flackereffekt der Flammenstrahlung genutzt. Dabei wird über ein optoelektronisches Fühlerelement die aufgenommene Wechselstrahlung in ein elektrisches Abbildungssignal gewandelt und anschließend dessen pulsierende Komponente in Rechtecksignale umgeformt. Durch Gleichrichtung der Rechtecksignalspannung entsteht das Flammenanwesenheitssignal, welches einer der Prozeßsteuerung dienenden Schalteinheit zugeführt wird.

Als Problem stellt sich dar, daß der Fühler auch Störsignale aufnimmt, die durch externe Fehlererscheinungen (Anlagenfehler) in die elektronische Überwachungseinrichtung einstreuen (z. B. netzspannungsführende Leitungen mit einer Störfrequenz von 50 Hz) bzw. einstrahlen (netzspannungsgespeiste Beleuchtungskörper mit einer Störfrequenz von 100 Hz). Die Weiterleitung dieser Störsignale führt bei erloschener Flamme in der Überwachungseinrichtung zur Vortäuschung des Zustandes "Flamme vorhanden".

Bekannte Schaltungsanordnungen weisen deshalb im Signalweg spezielle analoge Filteranordnungen auf, die die entsprechenden Störfrequenzbereiche sperren oder den Übertragungsbereich unterhalb der Störfrequenz begrenzen, wie z. B. aus DE—A—2 142 222 und 2 643 792 sowie aus DD—A—143 653 und 145 873 hervorgeht. Bei der Festlegung der Übertragungsbereichsgrenzen müssen bei diesen Anordnungen auch der mögliche Schwankungsbereich der Störfrequenz sowie die Temperaturabhängigkeit und die Langzeitänderung der Filterelemente und der Schaltwerte von Schwellwertschaltern Berücksichtigung finden, so daß zur Erreichung der erforderlichen Sicherheit gegen Flammenvortäuschung ein breiter Sperrbereich eingeführt werden muß. Die damit verbundene erhebliche Einschränkung des Übertragungsbereiches, der beispielsweise bei der aus DD—A—145 873 ersichtlichen Schaltungsanordnung 5 bis 40 Hz beträgt, hat zur Folge daß die Übewachungseinrichtung nicht den gesamten typischen Flackerfrequenzbereich der Flamme erfassen kann, welcher etwa zwischen 5 und 500 Hz liegt.

In der Praxis sind die entstehenden Flackerfrequenzen entlang der Flammenachse unterschiedlich groß, wobei die höheren Frequenzen im Flammenkern und die tieferen Frequenzen in der Flammenspitze auftreten. Durch die Einschränkung des Übertragungsbereiches wird deshalb ein exaktes Ausrichten der Fühlersichtöffnung auf den Teil der Flamme erforderlich, der innerhalb des Übertragungsbereiches der Überwachungseinrichtung liegende Flackerfrequenzen aufweist. Diese Einschränkung ist nachteilig, weil die Bestimmung und Realisierung einer entsprechenden Fühlersichtöffnung oft nur mit erheblichem Aufwand vor Ort der Feuerungsanlage erreichbar ist und nicht selten zu Kompromißlösungen führt, die eine verringerte Verfügbarkeit der Feuerungsanlage und einen überhöhten Kontroll- und Wartungsaufwand mit sich bringen.

Hier will die Erfindung Abhilfe schaffen. Die Erfindung, wie sie in den Ansprüchen gekennzeichnet ist, löst die Aufgabe, einen Wechselstrahlungsflammenwächter mit Störsignalunterdrückung zur Flammenüberwachung von vorwiegend Einzelbrennerfeuerungen für feste, flüssige oder gasförmige Brennstoffe zu schaffen, der mit geringem Bauelementeaufwand eine hohe Verfügbarkeit und Sicherheit gegen Flammenvortäuschung durch aufgenommene Störsignale realisiert, ohne daß eine exakte, mit entsprechend hohem Inbetriebnahme- und Wartungsaufwand verbundene Ausrichtung der Fühlersichtöffnung auf einen bestimmten Flammenbereich erforderlich ist, dadurch, daß im Signalweg zwischen dem Impulsformer und dem Kondensator ein D-Flip-Flop angeordnet ist, an dessen Informationseingang die Rechtecksignalspannung liegt und dessen Takteingang an eine mit der Frequenz des Störsignals arbeitende Taktsignalquelle angeschlossen ist.

Im allgemeinen sind als Störsignale Netzfrequenzeinstreuungen und Fremdlichteinfall durch netzspannungsgespeiste Beleuchtungskörper zu berücksichtigen, so daß die Taktsignalquelle vorzugsweise aus einer Netzspannungsquelle mit nachgeschaltetem Impusformer besteht.

Zur Begrenzung des Übertragungsbereiches oberhalb des typischen Flackerfrequenzbereiches ist bevorzugt dem Informationseingang des D-Flip-Flops ein Tiefpaß mit folgendem Schwellwertschalter vorgeschaltet.

Anschließend soll der erfindungsgemäße Wechselstrahlungsflammenwächter in Funktion beschrieben werden. Die aus dem pulsierenden Anteil der Flammenstrahlung durch das Fühlerelement gewandelten analogen Abbildungssignale werden mittels eines Impulsformers in bekannter Weise in digitale Signale geformt, deren Impulsfolgefrequenz der Frequenz der aufgenommenen Abbildungssignale entspricht. Die folgende Reihenschaltung des Tiefpasses und des Schwellwertschalters bewirkt die obere Begrenzung des Übertragungsbereiches und die Ansteuerung des D-Flip-Flops mit Signalen der erforderlichen Flankensteilheit. Infolge der Ansteuerung des Takteinganges des D-Flip-Flops mit Rechtecksignalen der Frequenz des Störsignals erscheint bei erloschener Flamme und an Informationseingang des D-Flip-Flops anliegenden Störsignalen am Ausgang des D-Flip-Flops ein konstanter Pegel, der über den nachfolgenden Kondensator nicht weitergeleitet wird. Unterscheidet sich dagegen die am Informationseingang des D-Flip-Flops liegende Frequenz der Rechtecksignalspannung von der Frequenz des Störsignals, was bei aufgenommenem Flammensignal der Fall ist, dann entstehen am Ausgang des D-Flip-Flops Impulsspannungen, welche in bekannter Weise gleichgerichtet und danach der Schalteinheit zugeführt werden.

Durch die Erfindung wird somit ein Wechselstrahlungsflammenwächter bereitgestellt, der den gesamten typischen Flackerfrequenzbereich der Flamme überträgt und der die Störsignalunterdrückung ohne Anwendung analoger Filter realisiert. Außerdem weist er innerhalb des Übertragungsbereiches nur sehr schmale, exakt der Frequenz des Störsignals und deren ganzzahligen Vielfachen entsprechende Sperrbereiche auf. Das Störsignal wird unabhängig von dessen Amplitude absolut gesperrt, wobei die Sperrbereiche den Frequenzschwankungen des Störsignals folgen.

Im folgenden wird die Erfindung anhand eines Ausführungsbeispiels und der Zeichnungen näher erläutert. Es zeigen:

Figur 1 ein Prinzipschaltbild des Wechselstrahlungsflammenwächters mit Störsignalunterdrückung und

Figur 2 ein Impulsdiagramm für ein netzfrequentes Störsignal.

Es wird ein Wechselstrahlungsflammenwächter beschrieben, der bei Flackerfrequenzen der zu überwachenden Flamme im gesamten typischen Flackerfrequenzbereich ein Flammenanwesenheitssignal erzeugt und bei dem Störsignale mit Netzfrequenz und deren ganzzahligen Vielfachen bei erloschener Flamme nicht zur Flammenvortäuschung führen.

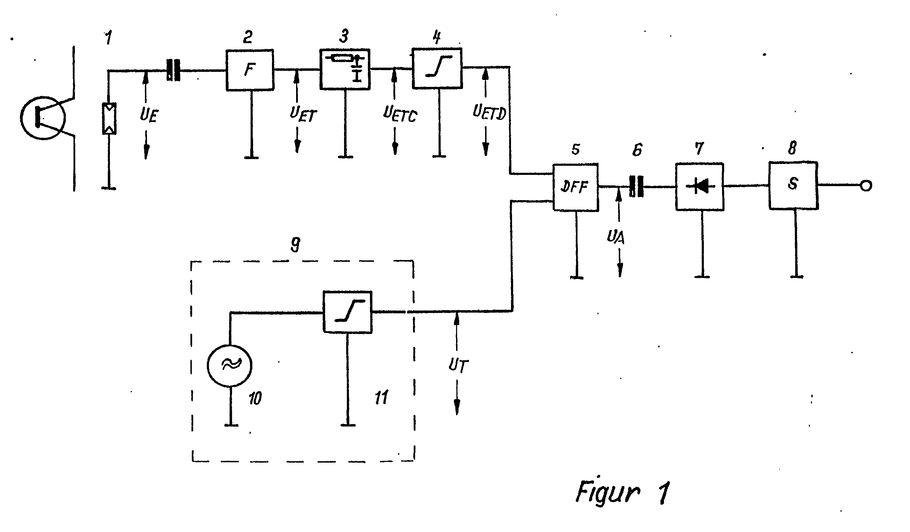

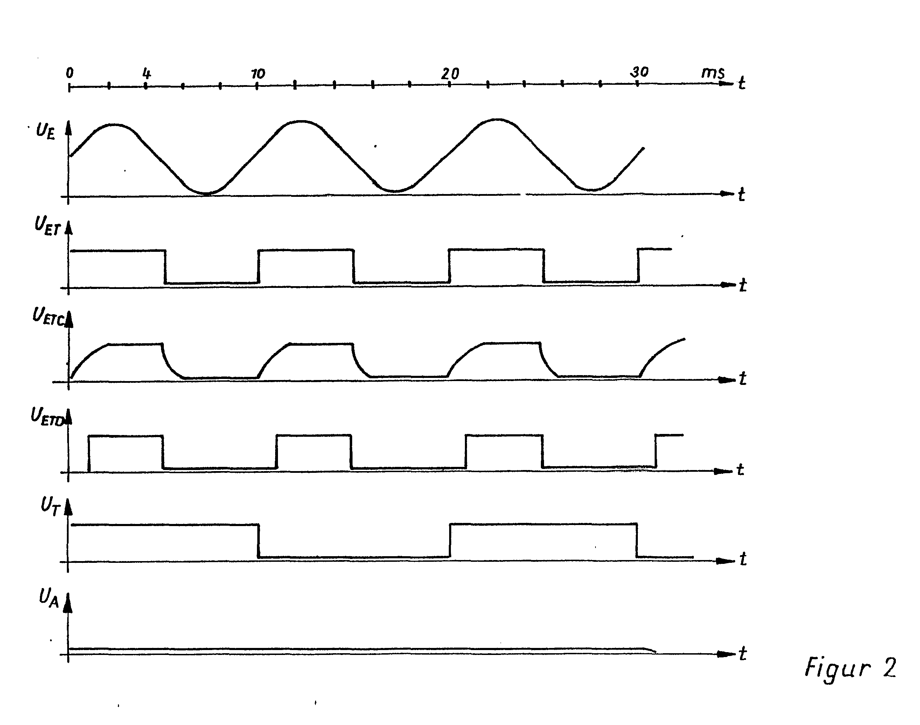

Das optoelektronische Fühlerelement 1 gemäß Figur 1, welches auf die Flamme gerichtet ist, ohne daß besondere Anforderungen an eine exakte Ausrichtung auf einen bestimmten Flammenbereich gestellt werden müssen, wandelt deren Strahlung in die elektrische Abbildungssignalspannung $U_E$, die aus einer Gleichspannung besteht, der eine der aufgenommenen Flackfrequenz entsprechende Wechselsignalspannung überlagert ist (s. a. Fig. 2). Der analoge Wechselspannungsanteil wird mittels des Impulsformers (F) 2 in die digitale Rechtecksignalspannung $U_{ET}$ umgeformt. Die Tiefpaß 3, bestehend aus einem Widerstand und einem Kondensator, ist so dimensioniert, daß bei Frequenzen der Signalspannung oberhalb 500 Hz die Eingangsspannung des Schwellwertschalters 4 unter der Schwellspannung bleibt.

Signalspannungen mit Frequenzen innerhalb des Übertragungsbereiches werden mittels des Schwellwertschalters 4 erneut in digitale Signale der erforderlichen Flankensteilheit umgeformt. Die so erzeugte Rechtecksignalspannung $U_{ETD}$ liegt am Informationseingang des D-Flip-Flops (DFF) 5.

Der Impulsformer 11, dessen Eingang mit der netzgespeisten Spannungsquelle 10 verbunden ist, erzeugt digitale Taktsignale mit Netzfrequenz, die an den Takteingang des D-Flip-Flops 5 gelangen.

Mit der L/H-Flanke der Taktspannung $U_T$ (Taktflanke) wird der am Informationseingang anliegende Pegel (L oder H) auf den Ausgang des D-Flip-Flops 5 durchgeschaltet. Das D-Flip-Flop 5 speichert diesen Pegel bis zur nächsten Taktflanke.

Zwischenzeitliche Pegeländerungen am Informationseingang sind wirkungslos.

Entstehen am Eingang des Flammenwächters oder im Signalweg Störsignale mit Netzfrequenz oder einem ganzzahligen Vielfachen der Netzfrequenz, so liegt zu jeder Taktflanke am Informationseingang des D-Flip-Flops 5 der gleiche Pegel L oder H an. Am Ausgang des D-Flip-Flops 5 werden somit keine Impulsspannungen, sondern ein konstanter Pegel L oder H ausgegeben, der über deen nachfolgenden Kondensator 6 nicht weitergeleitet wird, so daß Signale, die im Fehlerfall aus netzgespeisten Störquellen eingespeist werden, nicht zur Flammenvortäuschung führen können.

Bei vorhandener Flamme liegt am Informationseingang des D-Flip-Flops 5 die Rechtecksspannung $U_{ETD}$ mit der weckselnden Frequenz des aufgenommenen Flammensignals, so daß am Ausgang des D-Flip-Flops 5 Impulsspannungen $U_A$ entstehen, die über den Kondensator 6 weitergeleitet und mittels der Gleichrichterschaltung 7 in eine negative, der Betriebsspannung entgegengesetzte Ausgangsspannung gewandelt werden, die der Ansteuerung der Schalteinheit (S) 8 dient.

**Patentansprüche**

1. Wechselstrahlungsflammenwächter mit Störsignalunterdrückung zur Unterdrückung von Störsigalen mit bekannten Frequenz bestehend aus einer optoelektronischen Fühlereinheit und einer elektronischen Auswerte- und Schalteinheit, bei dem an das optoelektronische Fühlerelement (1) ein Impulsformer (2), der eine Rechteckspannung erzeugt, angeschlossen ist und bei dem am Ausgang durch einen Kondensator (6) galvanisch getrennt eine Gleichrichterschaltung (7) vorhanden ist, an die sich eine Schalteinheit (8) anschließt, dadurch gekennzeichnet, daß im Signalweg zwischen dem Impulsformer (2) und dem Kondensator (6) ein D-Flip-Flop (5) angeordnet ist, an dessen Informationseingang die Rechtecksignalspannung liegt und dessen Takteingang an eine mit der Frequenz des Störsignals arbeitende Taktsignalquelle (9) angeschlossen ist.

2. Wechselstrahlungsflammenwächter nach Anspruch 1, bei dem die Taktsignalquelle (9) aus einer Netzspannungsquelle (10) mit nachgeschaltetem Impulsformer (11) besteht.

3. Wechselstrahlungsflammenwächter nach Anspruch 1 oder 2, bei dem dem Informationseingang des D-Flip-Flops (5) ein Tiefpaß (3) mit nachfolgendem Schwellwertschalter (4) vorgeschaltet ist.

**Revendications**

1. Dispositif de surveillance de flamme à rayonnement alterné avec suppression des signaux parasites de fréquence connue, dispositif composé d'un capteur opto-électronique et d'un circuit électronique d'exploitation et de commutation dont l'élément de capteur opto-électronique (1) est relieé à un formeur d'impulsions (2) générant une tension rectangulaire, et dont la sortie est reliée à un redresseur (7) en étant découplée de manière galvanique par un condensateur (6), redresseur suivi d'un élément de commutation (8), dispositif caractérisé en ce que dans le chemin du signal entre le circuit de mise en forme d'impulsions (2) et le condensateur (6), il est prévu un flip-flop D (bascule bistable D) (5) dont l'entrée d'information reçoit la tension de signal rectangulaire et dont l'entrée d'horloge est reliée à une source de signaux d'horloge (9) fonctionnant à la fréquence du signal parasite.

2. Dispositif de surveillance de flamme à rayonnement alterné selon la revendication 1, caractérisé en ce que la source de signaux d'horloge (9) est une source à la tension de réseau (10) comportant en aval un circuit de mise en forme d'impulsions (11).

3. Dispositif de surveillance de flamme à rayonnement alterné selon la revendication 1 ou la revendication 2, caractérisé en ce que l'entrée d'information du flip-flop D (5) est précédée d'un filtre passe-bas (3) suivi d'un commutateur à valeur de seuil (4).

**Claims**

1. A variable radiation flame monitor with interference signal suppression for the suppression of interference signals having a known frequency, consisting of an optoelectronic sensor unit and an electronic evaluation and switching unit, wherein to the optoelectronic sensor element (1) a pulse shaper (2) generating a square-wave voltage is connected and wherein at the output, galvanically separated by a capacitor (6), a rectifying circuit (7) is provided which is followed by a switching unit (8), characterized in that in the signal path between the pulse shaper (2) and the capacitor (6) a D-flip-flop (5) is disposed to the information input of which the rectangular signal voltage is applied and whose clock input is connected to a clock signal source (9) operating at the frequency of the interference signal.

2. The variable radiation flame monitor according to claim 1, wherein the clock signal source (9) consists of a mains voltage source (10) followed by a pulse shaper (11).

3. The variable radiation flame monitor according to claim 1 or claim 2, wherein a low pass (3) followed by a threshold switch (4) is connected in series before the information input of the D-flip-flop (5).

Figur 1

EP 0 229 265 B1

Figur 2